# EUROPEAN PATENT APPLICATION

(11) **EP 4 810 924 A1**
(43) Date of publication of application: **23.09.2026**
(21) Application number: 26165372.9
(22) Date of filing: 17.03.2026
(51) Int. Cl.: G01J 1/04, B33Y 30/00, G01J 1/42, B22F 10/36

(54) **METHODS OF REPRODUCIBLY DETERMINING BEAM SIZE PARAMETERS OF A LASER BEAM UTILIZING A CALIBRATION STANDARD AND ADDITIVE MANUFACTURING SYSTEMS THAT PERFORM THE METHODS**

(30) Priority: 18.03.2025 US 202519082971
(71) Applicant: The Boeing Company, Arlington, VA 22202 (US)
(72) Inventor: HENSHAW, Dana A., ARLINGTON, 22202 (US); HARRIS, Darron M., ARLINGTON, 22202 (US); CHAPMAN, Eric M., ARLINGTON, 22202 (US); HAMBURG, Dalton W., ARLINGTON, 22202 (US); JOHNSON, Matthew C., ARLINGTON, 22202 (US)
(74) Representative: Plasseraud IP

(57) **Abstract**

Methods of reproducibly determining a beam size parameter of a laser beam utilizing a calibration standard and additive manufacturing systems that perform the methods. The calibration standard includes a calibration body that includes an aperture and defines a plurality of distinct aperture dimensions. Each distinct aperture dimension is measured along a corresponding dimension vector. The method includes, for each distinct aperture dimension, scanning the laser beam across the calibration body and along the corresponding dimension vector and, during the scanning, measuring a resultant energy of the laser beam as a function of position along the corresponding dimension vector. The method also includes generating an energy-dimension correlation between a characteristic of the resultant energy of the laser beam for each distinct aperture dimension and the distinct aperture dimension. The method further includes determining the beam size parameter based, at least in part, on the energy-dimension correlation.

## Description

### FIELD

The present disclosure relates generally to methods of reproducibly determining a beam size parameter of a laser beam utilizing a calibration standard and additive manufacturing systems that perform the methods.

### BACKGROUND

Laser beams may be produced by laser light sources and utilized in a variety of industrial processes. As an example, a laser beam may be utilized in an additive manufacturing process to provide energy to, or to heat, a feedstock material, such as to melt the feedstock material and/or to facilitate consolidation of the feedstock material to define an additively manufactured component. In some applications, it may be desirable, or even necessary, to accurately know one or more characteristics of the laser beam, such as an energy of the laser beam, a focal point of the laser beam, and/or a shape of the laser beam. However, laser light sources generally produce laser beams with characteristics that may vary with time, with temperature, and/or with age of the laser light source. Thus, it may be beneficial to characterize, to quantify, and/or to calibrate the one or more characteristics of the laser beam. Commercially available products for characterization of laser light beams generally cannot be independently calibrated, which may be unacceptable in certain industrial applications where stringent quality control standards exist. Thus, there exists a need for improved methods of reproducibly determining a beam size parameter of a laser beam utilizing a calibration standard and/or for additive manufacturing systems that perform the methods.

### SUMMARY

Methods of reproducibly determining a beam size parameter of a laser beam utilizing a calibration standard and additive manufacturing systems that perform the methods are disclosed herein and are defined by the independent claim 1.

The additive manufacturing systems are configured to form an additively manufactured component and are defined by the independent claim 15.

### BRIEF DESCRIPTION OF THE DRAWINGS

Fig. 1 is a schematic illustration of examples of an additive manufacturing system that may perform methods, according to the present disclosure.
Fig. 2 is a schematic illustration of another example of an additive manufacturing system that may perform methods, according to the present disclosure.
Fig. 3 is a schematic illustration of examples of a calibration standard that may be utilized with additive manufacturing systems and/or methods, according to the present disclosure.
Fig. 4 is a less schematic illustration of an example of a calibration standard that may be utilized with additive manufacturing systems and/or methods, according to the present disclosure.
Fig. 5 is a less schematic illustration of an example of a calibration standard that may be utilized with additive manufacturing systems and/or methods, according to the present disclosure.
Fig. 6 is a less schematic illustration of an example of a calibration standard that may be utilized with additive manufacturing systems and/or methods, according to the present disclosure.
Fig. 7 is a less schematic illustration of an example of a calibration standard that may be utilized with additive manufacturing systems and/or methods, according to the present disclosure.
Fig. 8 is a less schematic illustration of an example of a calibration standard that may be utilized with additive manufacturing systems and/or methods, according to the present disclosure.
Fig. 9A is a schematic illustration of examples of a laser beam being scanned across a calibration standard, according to the present disclosure.
Fig. 9B is a schematic illustration of examples of a laser beam being scanned across a calibration standard, according to the present disclosure.
Fig. 9C is a schematic illustration of examples of a laser beam being scanned across a calibration standard, according to the present disclosure.
Fig. 10 is a plot illustrating resultant energy of a laser beam as a function of position when the resultant energy includes a transmitted fraction of the laser beam.
Fig. 11A is a schematic illustration of examples of a laser beam being scanned across an aperture with a first distinct aperture dimension, according to the present disclosure.
Fig. 11B is a schematic illustration of examples of a laser beam being scanned across an aperture with a second distinct aperture dimension, according to the present disclosure.
Fig. 11C is a schematic illustration of examples of a laser beam being scanned across an aperture with a third distinct aperture dimension, according to the present disclosure.
Fig. 11D is a schematic illustration of examples of a laser beam being scanned across an aperture with a fourth distinct aperture dimension, according to the present disclosure.
Fig. 12 is a plot illustrating resultant energy of a laser beam as a function of position for the plurality of distinct aperture dimensions illustrated in Figs. 11A-11D when the resultant energy includes a transmitted fraction of the laser beam.
Fig. 13 is a plot illustrating an example of an energy-dimension correlation, according to the present disclosure, when a resultant energy includes a transmitted fraction of a laser beam.
Fig. 14 is a plot illustrating resultant energy of a laser beam as a function of position for the plurality of distinct aperture dimensions illustrated in Figs. 11A-11D when the resultant energy includes a reflected fraction of the laser beam.
Fig. 15 is a plot illustrating an example of an energy-dimension correlation, according to the present disclosure, when resultant energy includes a reflected fraction of the laser beam.
Fig. 16 is a flowchart depicting examples of methods of determining a beam size parameter of a laser beam utilizing a calibration standard, according to the present disclosure.

### DESCRIPTION

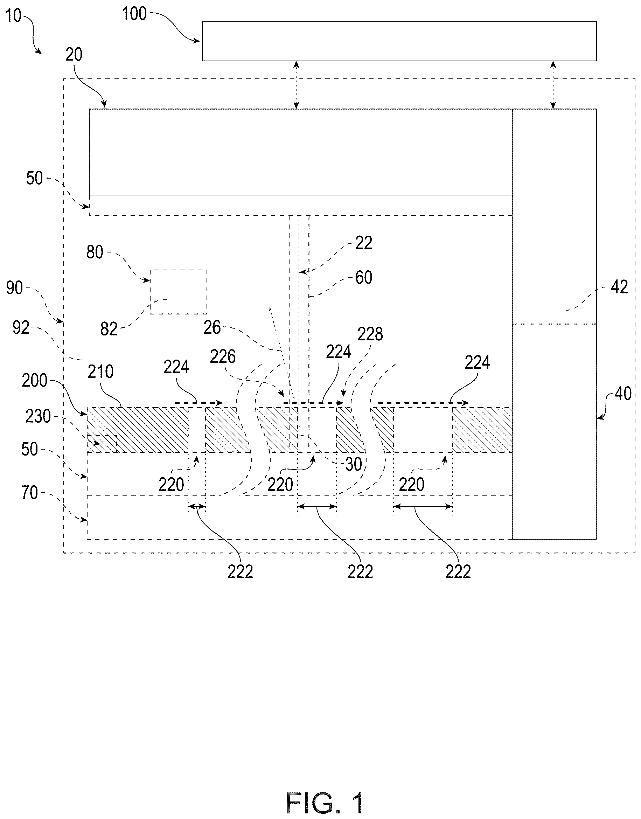

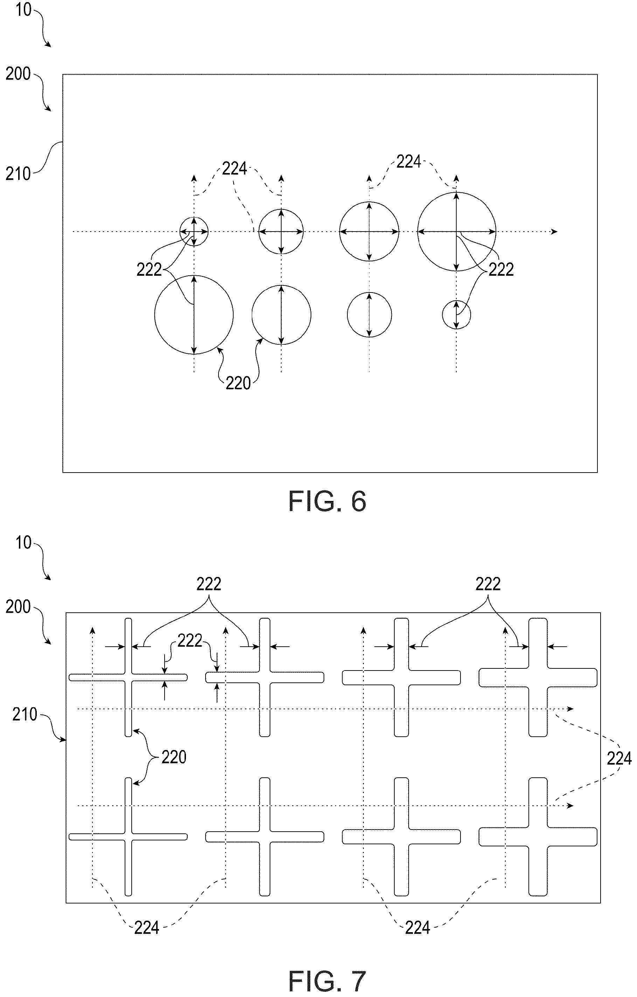

Figs. 1-16 provide illustrative, non-exclusive examples of additive manufacturing systems 10, calibration standards 200, and/or methods 300, according to the present disclosure. Elements that serve a similar, or at least substantially similar, purpose are labeled with like numbers in each of Figs. 1-16, and these elements may not be discussed in detail herein with reference to each of Figs. 1-16. Similarly, all elements may not be labeled in each of Figs. 1-16, but reference numerals associated therewith may be utilized herein for consistency. Elements, components, and/or features that are discussed herein with reference to one or more of Figs. 1-16 may be included in and/or utilized with any of Figs. 1-16 without departing from the scope of the present disclosure.

In general, elements that are likely to be included in a given (i.e., a particular) embodiment are illustrated in solid lines, while elements that may be optional to a given embodiment are illustrated in dashed lines. However, elements that are shown in solid lines are not essential to all embodiments, and an element shown in solid lines may be omitted from a particular embodiment without departing from the scope of the present disclosure.

Figs. 1-2 are schematic illustrations of examples of additive manufacturing systems 10 that may perform methods 300, according to the present disclosure. Additive manufacturing systems 10 may be configured to form an additively manufactured component. As collectively illustrated by Figs. 1-8, and as discussed in more detail herein, additive manufacturing systems 10 include a calibration standard 200 that includes a calibration body 210. The calibration body includes an aperture 220, and the calibration standard defines a plurality of distinct aperture dimensions 222, with each distinct aperture dimension 222 being measured and/or defined along a corresponding dimension vector 224. Turning more specifically to Figs. 1-2, additive manufacturing systems 10 also include a laser light source 20, a translation structure 40, and a controller 100.

Laser light source 20 is configured to direct a laser beam 22 incident upon calibration standard 200. This may be accomplished in any suitable manner. As an example, laser light source 20 may be configured to produce, generate, and/or emit laser beam 22. As another example, laser light source 20 may include one or more optical components, lenses, reflective surfaces, mirrors, and/or fiber optic cables, which may be configured to direct laser beam 22 toward and/or incident upon calibration standard 200. Examples of laser light source 20 include a fiber laser, a CO2 laser, and/or a Nd:YAG laser.

Translation structure 40 is configured to scan laser beam 22 across calibration body 210 of calibration standard 200. This may be accomplished in any suitable manner. As an example, translation structure 40 may be configured to move calibration body 210 relative to laser light source 20 and/or relative to laser beam 22, such as within a plane of incidence between laser beam 22 and calibration body 210. Such a configuration may permit an angle of incidence between laser beam 22 and calibration body 210 to remain constant, or at least substantially constant, as translation structure 40 scans laser beam 22 across calibration body 210. As another example, translation structure 40 may be configured to move laser beam 22 relative to calibration body 210. In some such examples, translation structure 40 also may be referred to herein as and/or may be a beam scanner 42. Beam scanners 42 often may be conventional to additive manufacturing systems. As such, utilization of beam scanners 42 to scan laser beam 22 across calibration body 210 may decrease a need for an additional and/or separate translation structure to be added to a conventional additive manufacturing system when utilized to perform methods 300 that are disclosed herein. However, it is within the scope of the present disclosure that additive manufacturing system 10 may include both beam scanner 42 and a separate translation structure 40 that is configured to move calibration standard 200 relative to laser light source 20, relative to laser beam 22, and/or relative to beam scanner 42.

Translation structure 40 may include any suitable structure that may be adapted, configured, designed, and/or constructed to scan laser beam 22 across calibration body 210. Examples of translation structure 40 include an actuator, a linear actuator, a rotary actuator, a rack and pinion assembly, a lead screw and nut assembly, a ball screw and nut assembly, a moveable lens for laser beam 22, and/or a moveable reflective surface for laser beam 22.

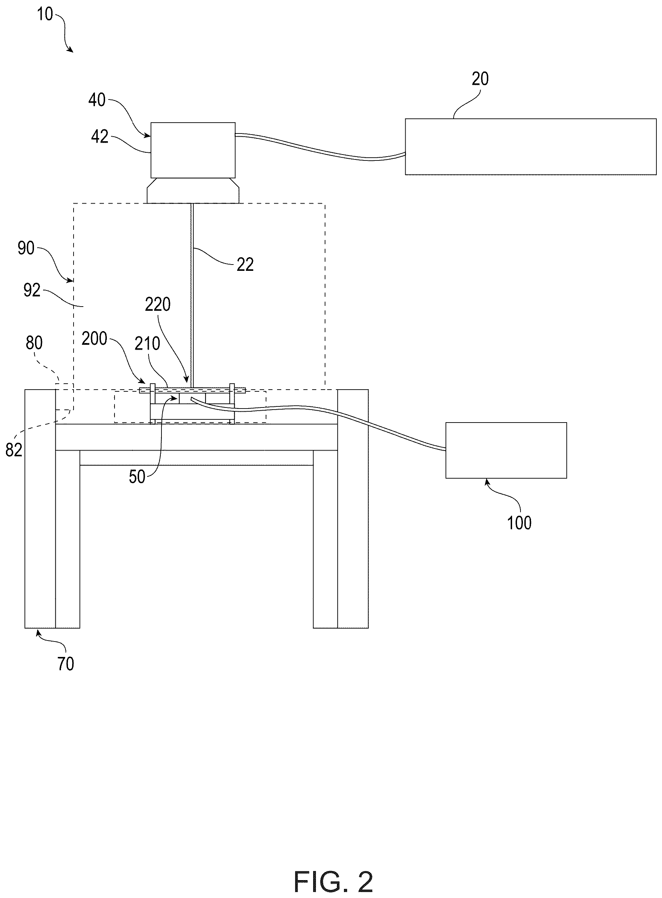

As illustrated in dashed lines in Fig. 1 and in solid lines in Fig. 2, additive manufacturing systems 10 also may include an optical energy detector 50. Optical energy detector 50 may be adapted, configured, designed, and/or constructed to detect, measure, determine, and/or quantify a resultant energy of laser beam 22. As used herein, the phrase "resultant energy" refers any suitable measure and/or quantification of any suitable energy parameter of laser beam 22 subsequent to interaction between laser beam 22 and calibration standard 200 and/or calibration body 210 thereof. Stated differently, the "resultant energy" of laser beam 22 is the energy of a fraction, a subset, and/or a portion of laser beam 22 after the fraction, portion, and/or subset of the laser beam has passed through aperture 220 of calibration standard 200 and/or after the fraction, portion, and/or subset of the laser beam has been reflected from calibration body 210, as is discussed in more detail herein. Examples of optical energy detector 50 include a thermopile, a charge coupled device (CCD) optical detector, a complementary metal-oxide-semiconductor (CMOS) optical detector, a photodiode, a calorimeter, and/or an integrating sphere.

In some examples, and as illustrated in Figs. 1-2, calibration standard 200 may be positioned between laser light source 20 and optical energy detector 50. In such examples, the resultant energy of laser beam 22 includes energy of at least a fraction of a transmitted fraction 30 of the laser beam that is transmitted through aperture 220, as illustrated in Fig. 1. In some examples, and as also illustrated in Fig. 1, optical energy detector 50 additionally or alternatively may be positioned to detect a reflected fraction 26 of laser beam 22 that is reflected from calibration body 210.

With continued reference to Fig. 1, and in some examples, additive manufacturing systems 10 also may include an attenuation structure 60. Attenuation structure 60, when present, may be adapted, configured, designed, constructed, and/or positioned to attenuate laser beam 22. This may include attenuation of laser beam 22 prior to laser beam 22 being incident upon optical energy detector 50, attenuation of laser beam 22 prior to laser beam 22 being incident upon calibration standard 200, attenuation of laser beam 22 to decrease a potential for damage to optical energy detector 50 by laser beam 22, and/or attenuation of laser beam 22 to decrease a potential for damage to calibration standard 200 by laser beam 22.

In a more specific example, and as discussed, laser beam 22 may be configured to melt a feedstock material 82, such as to consolidate the feedstock material to form and/or define the additively manufactured component. With this in mind, laser beam 22 may have and/or exhibit a relatively high energy, and directing an unattenuated laser beam 22 incident upon optical energy detector 50 may heat optical energy detector 50, may melt optical energy detector 50, and/or may otherwise damage optical energy detector 50. Similarly, directing the unattenuated laser beam 22 incident upon calibration standard 200 may heat calibration standard 200, may melt calibration standard 200, may cause a change in one or more distinct aperture dimensions 222 of calibration standard 200, may decrease a useful service life of calibration standard 200, and/or may otherwise damage calibration standard 200.

Attenuation structure 60 may be positioned at any suitable location within additive manufacturing system 10 that attenuates laser beam 22 prior to laser beam 22 being incident upon optical energy detector 50 and/or prior to laser beam 22 being incident upon calibration standard 200. In addition, attenuation structure 60 may include any suitable component and/or structure. Examples of attenuation structure 60 include a partially reflective structure, a partially transmissive structure, a partially absorptive structure, and/or the integrating sphere.

With continued reference to Figs. 1-2, and in some examples, additive manufacturing systems 10 may include a support platform 70. Support platform 70 may be adapted or configured to support at least one of the additively manufactured component and the calibration standard. Examples of the support platform include any suitable platform, table, and/or machine support structure.

Additive manufacturing systems 10 also may include a volume of feedstock material 82. As discussed, additive manufacturing systems 10 may be configured to utilize laser beam 22 to form a melt pool of feedstock material 82 and/or to consolidate the melt pool to form and/or define the additively manufactured component. Examples of the feedstock material include a powder feedstock material, a filament feedstock material, a polymeric feedstock material, a ceramic feedstock material, and/or a metallic feedstock material.

Additive manufacturing systems 10 also may include a feedstock supply system 80. Feedstock supply system 80 may be adapted or configured to supply feedstock material 82 to a desired location and/or region in and/or within additive manufacturing system 10. Examples of feedstock supply system 80 include a powder supply system, a filament supply system, a hopper, an auger, and/or a spool holder.

Additive manufacturing systems 10 also may include a build chamber 90. Build chamber 90 may at least partially define, surround, and/or bound a chamber volume 92 that may contain at least one component of additive manufacturing system 10, such as calibration standard 200 and/or optical energy detector 50. Examples of build chamber 90 include any suitable enclosure, housing, panel, and/or structure that may at least partially bound chamber volume 92.

Controller 100 is programmed to control operation of additive manufacturing system 10. This may include controlling any suitable component and/or subset of additive manufacturing system 10 in any suitable manner, including controlling according to methods 300, which are discussed in more detail herein. Examples of components of additive manufacturing system 10 that may be controlled by and/or that may be in communication with controller 100 include laser light source 20, translation structure 40, optical energy detector 50, attenuation structure 60, and/or feedstock supply system 80.

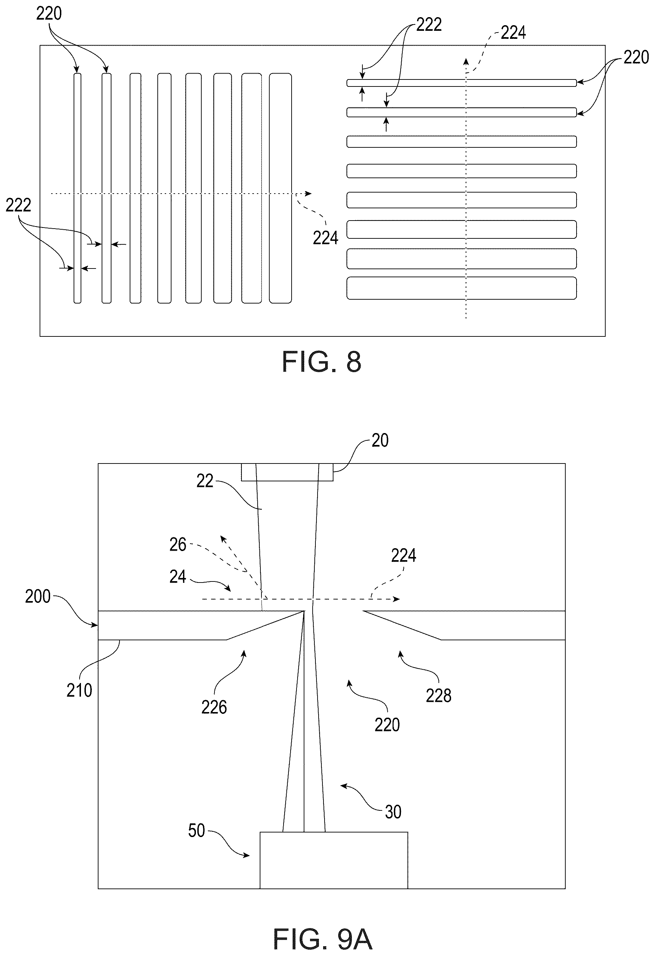

During operative use of additive manufacturing systems 10, and as discussed in more detail herein with reference to methods 300, laser beam 22 may be directed incident upon calibration body 210, and translation structure 40 may be utilized to scan laser beam 22 across calibration body 210 and along a corresponding dimension vector 224. This is perhaps best illustrated in Figs. 9A-9C, which illustrate relative motion between laser beam 22 and calibration body 210 such that laser beam 22 moves from left-to-right across calibration body 210 in the progression from Fig. 9A to Fig. 9C.

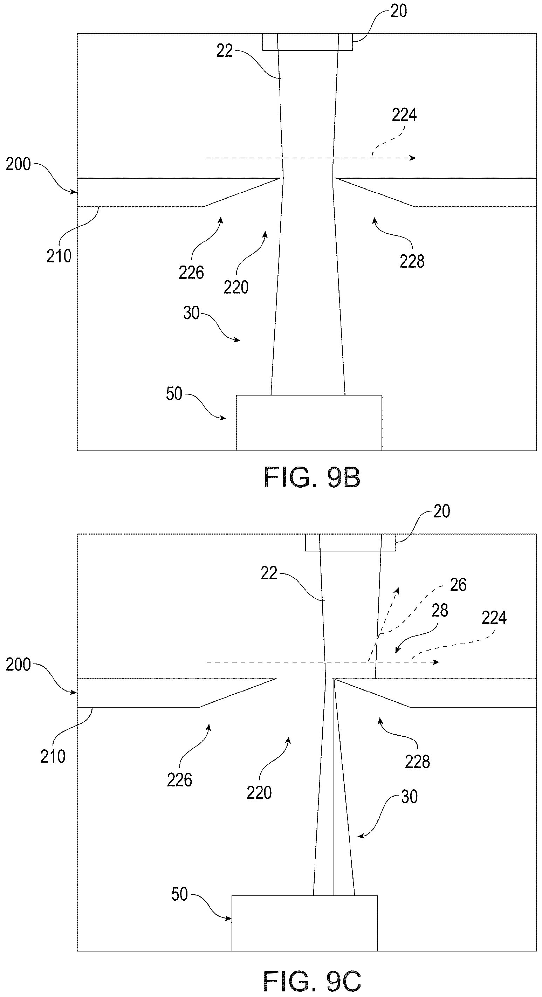

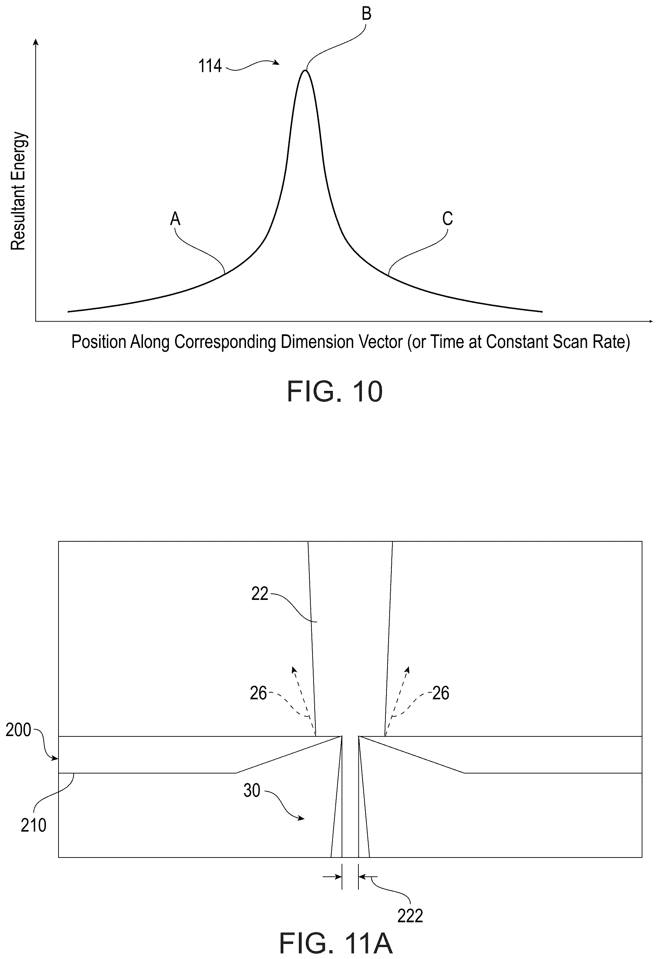

As illustrated, translation structure 40 may scan laser beam 22 across calibration body 210 such that at least a first fraction 24 of laser beam 22 initially is incident upon a first region 226 of calibration body 210, as illustrated in Fig. 9A, and also such that at least a second fraction 28 of laser beam 22 subsequently is incident upon a second region 228 of calibration body 210, as illustrated in Fig. 9C. In the examples of Figs. 9A-9C, where calibration body 210 is positioned between laser light source 20 and optical energy detector 50 and transmitted fraction 30 of laser beam 22 is detected by optical energy detector 50, the resultant energy of the laser beam as a function of position along corresponding dimension vector 224 (or, alternatively, as a function of time during the scan process for a constant scan rate) is illustrated in Fig. 10. In Fig. 10, the resultant energy detected while laser beam 22 and calibration body 210 are in the relative positions illustrated in Figs. 9A, 9B, and 9C are labelled as A, B, and C, respectively, and the scanning process generates a local maximum 114 in the resultant energy at a position along corresponding dimension vector 224 where a maximum fraction of laser beam 22 passes through aperture 220.

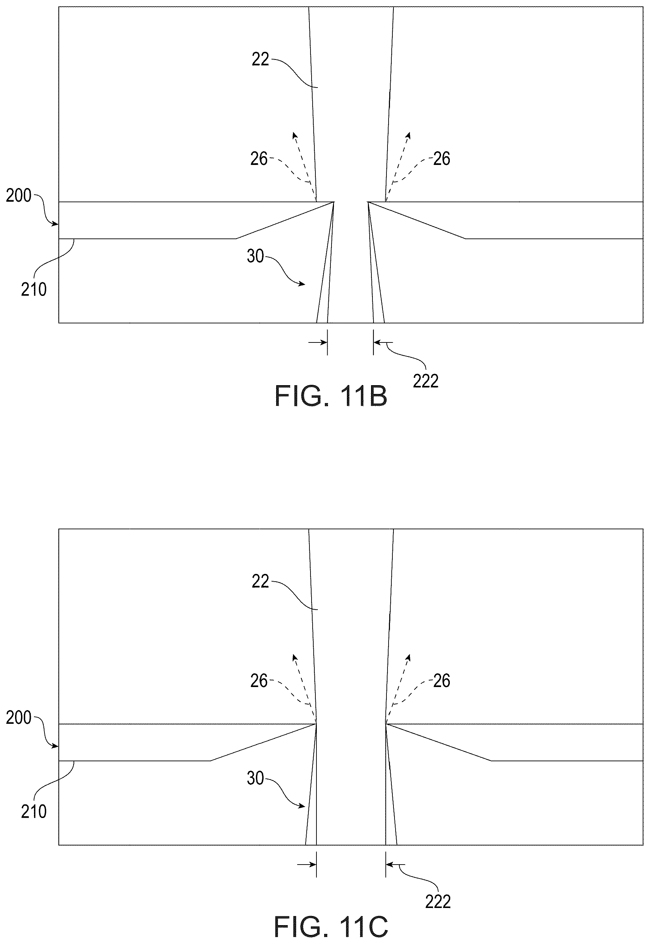

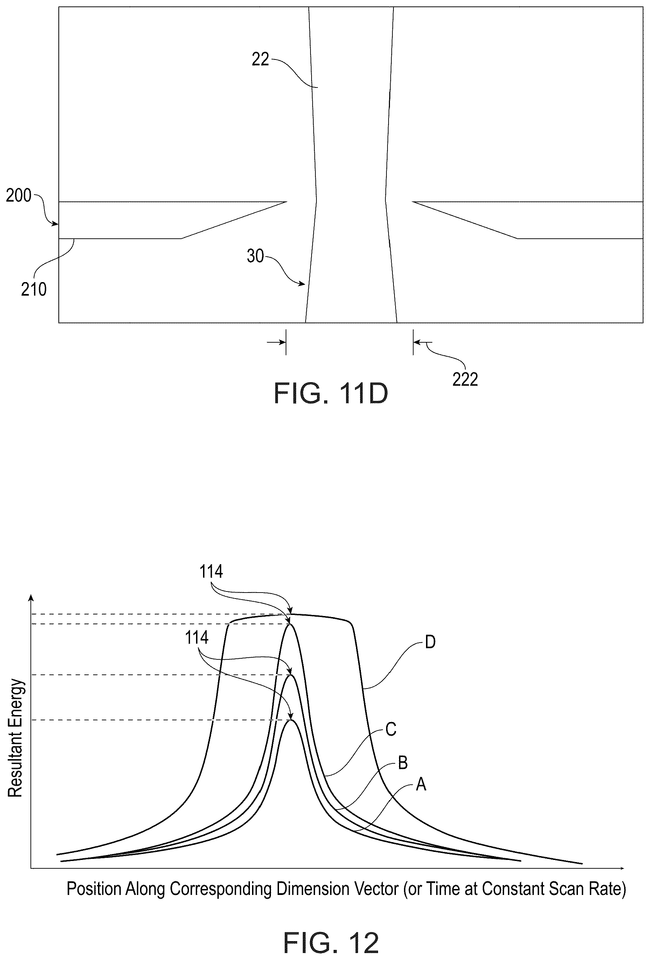

This scanning process may be repeated for a plurality of different characteristic aperture dimensions 222, as illustrated in Figs. 11A-11D, to produce a corresponding relationship between resultant energy and position along corresponding dimension vector 224 for each characteristic aperture dimension. This is illustrated in Fig. 12, with the corresponding relationship for the characteristic aperture dimension 222 that is illustrated in Figs. 11A-11D being indicated at A-D, respectively. As illustrated in Fig. 12, each relationship defines a corresponding local maximum 114.

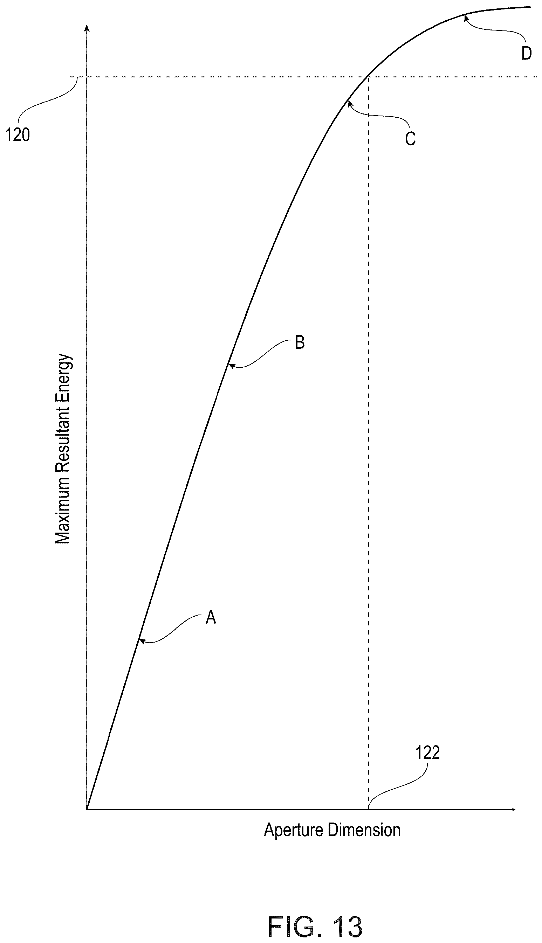

Subsequently, and as illustrated in Fig. 13, an energy-dimension correlation, which provides a correlation between a characteristic of the resultant energy of the laser beam for each distinct aperture dimension and the distinct aperture dimension, may be generated. In the example of Fig. 13, the energy-dimension correlation plots a maximum resultant energy for each relationship that is illustrated in Fig. 12 as a function of the corresponding distinct aperture dimension for that relationship. Stated differently, in Fig. 13, the characteristic of the resultant energy is the maximum resultant energy as indicated at 114 in Fig. 12. However, other characteristics of the resultant energy may be utilized.

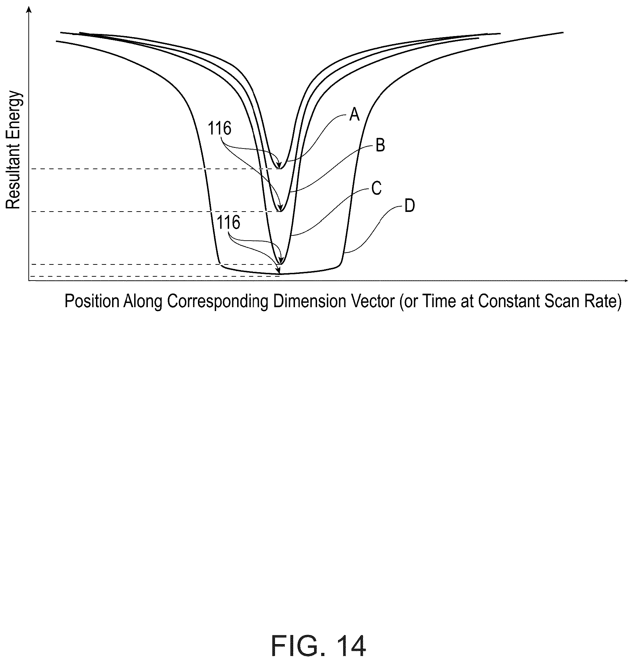

As discussed in more detail herein, it is within the scope of the present disclosure that optical energy detector 50 of additive manufacturing system 10 may detect, or may instead detect, reflected fraction 26 of laser beam 22. In such examples, repeating the scanning process that is illustrated in Figs. 9A-11D, and discussed in more detail herein, generates the corresponding relationships between resultant energy and position along corresponding dimension vector 224 for each characteristic aperture dimension that is illustrated in Fig. 14. Similar to Fig. 12, the corresponding relationship for the characteristic aperture dimension 222 that is illustrated in Figs. 11A-11D is indicated at A-D, respectively. As illustrated in Fig. 14, each relationship defines a corresponding local minimum 116.

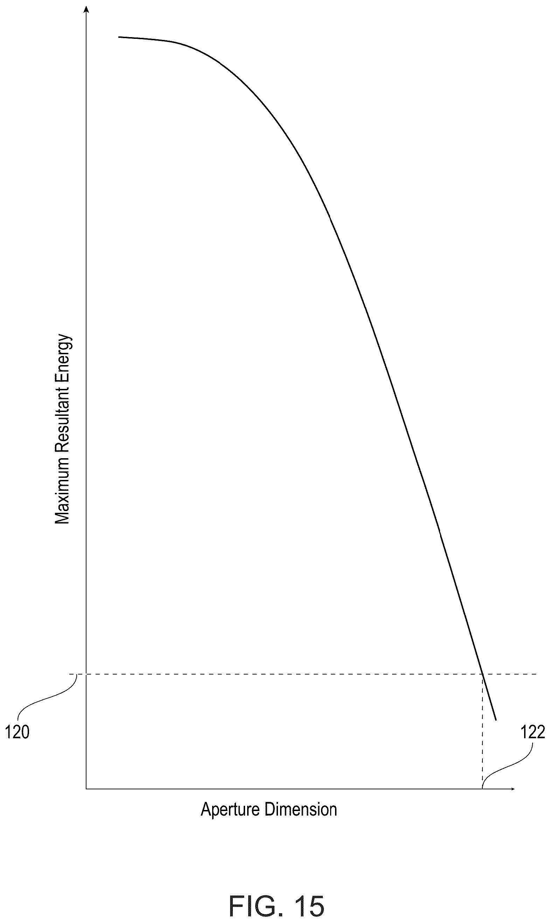

Subsequently, and as illustrated in Fig. 15, an energy-dimension correlation, which provides a correlation between a characteristic of the resultant energy of the laser beam for each distinct aperture dimension and the distinct aperture dimension, may be generated. In the example of Fig. 15, the energy-dimension correlation plots a minimum resultant energy for each relationship that is illustrated in Fig. 14 as a function of the corresponding distinct aperture dimension for that relationship. Stated differently, in Fig. 15, the characteristic of the resultant energy is the minimum resultant energy as indicated at 116 in Fig. 14. However, other characteristics of the resultant energy once again may be utilized.

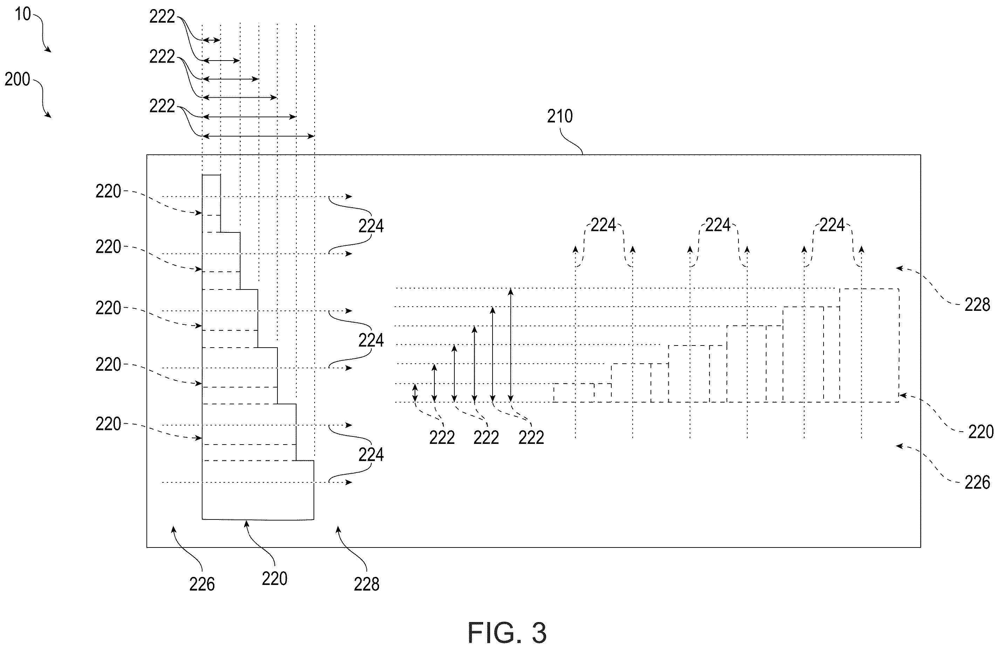

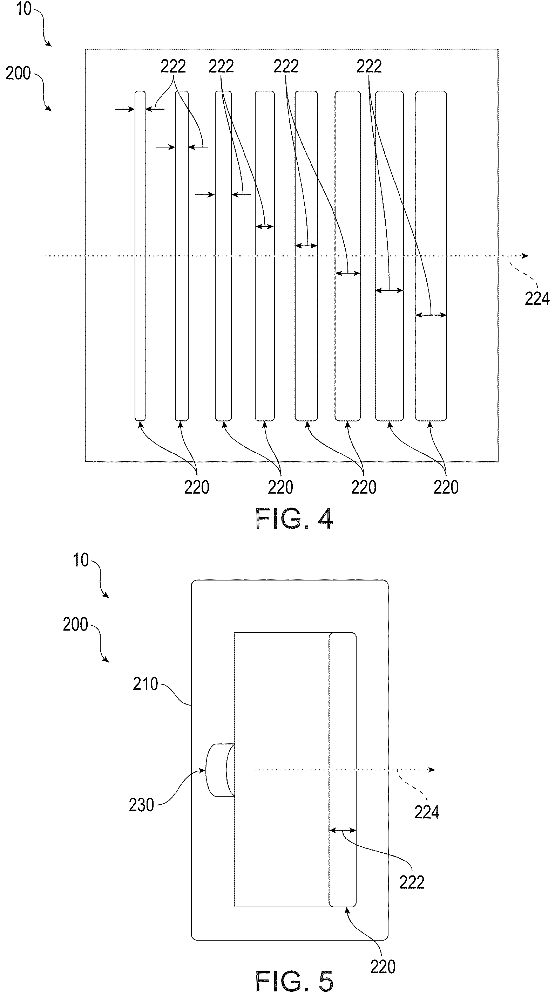

Calibration standards 200 may include any suitable structure that includes at least one calibration body 210 that includes at least one aperture 220 and/or that defines the plurality of distinct aperture dimensions 222. As an example, and as illustrated in solid lines on the left side of Fig. 3 and in Fig. 5, a single aperture 220 may define the plurality of distinct aperture dimensions. As an example, and as illustrated in Fig. 3, the single aperture 220 may define a stepped profile that defines the plurality of distinct aperture dimensions. As another example, and as illustrated in Figs. 1 and 5, calibration standard 200 may include an aperture size adjustment structure 230 configured to selectively adjust a single distinct aperture dimension of the single aperture 220, thereby permitting the single aperture 220 to define the plurality of distinct aperture dimensions. Examples of aperture size adjustment structure 230 include a micrometer, lead screw and nut assembly, a ball screw and nut assembly, and/or a sliding plate. Alternatively, and as illustrated in dashed lines on the left side of Fig. 3, and in solid lines in Figs. 4 and 6-8, a plurality of distinct and/or spaced-apart apertures may define the plurality of distinct aperture dimensions.

Apertures 220 may have and/or define any suitable shape. Examples of apertures 220 include square, rectangular, rectilinear, trapezoidal, circular, and/or plus-shaped apertures 220.

In some examples, and as discussed in more detail herein with reference to methods 300, calibration standards 200 may be utilized to characterize a shape, or a two-dimensional shape, of the laser beam within a transverse cross-section of the laser beam. In such examples, and as perhaps best illustrated in Figs. 3 and 6-8, calibration standards 200 may be configured to define distinct aperture dimensions 222 in two or more distinct directions and/or along two or more distinct corresponding dimension vectors that intersect one another.

Calibration standards 200 may include any suitable structure, such as calibration body 210, that forms and/or defines aperture 220 and the plurality of distinct aperture dimensions 222. In some examples, calibration body 210 may include and/or be a planar, or at least substantially planar, calibration body 210, or may define a planar, or at least substantially planar, surface, or upper surface, upon which laser beam 22 may be incident.

Calibration body 210 may be durable and/or may be configured to permit and/or facilitate repeated utilization thereof, such as within additive manufacturing system 10 and/or via methods 300, without damage to the calibration body and/or without changes to the plurality of distinct aperture dimensions 222. In some examples, calibration body 210 may be formed from a body material, examples of which include a thermally stable body material, a body material that resists degradation by electromagnetic energy at a wavelength of the laser beam, a reflective body material, and/or a thermally conductive body material. More specific examples of the body material include a metal, a stainless steel, and copper.

It is within the scope of the present disclosure that calibration standard 200 may include a single calibration body 210 that defines the plurality of distinct aperture dimensions or at least a subset of the plurality of distinct aperture dimensions. Additionally or alternatively, it is also within the scope of the present disclosure that calibration standard 200 may include a plurality of calibration bodies 210, each of which may include at least one corresponding aperture 220 that defines at least one distinct aperture dimension 222 of the plurality of distinct aperture dimensions 222.

As used herein, the phrase "aperture dimension" refers to a dimension and/or measurement of aperture 220 as measured along, or parallel to, the corresponding dimension vector. As an example, and as discussed in more detail herein, corresponding dimension vector 224 may extend across first region 226 of calibration body 210, across aperture 220, and across second region 228 of calibration body 210. In such an example, the aperture dimension is defined as a distance across aperture 220 between first region 226 and second region 228. For clarity, some Figures illustrate corresponding dimension vector 224 as being spaced-apart from a surface of calibration body 210. In such examples, it is understood that the aperture dimension is measured along a projection of corresponding dimension vector 224 that extends along the surface of calibration body 210.

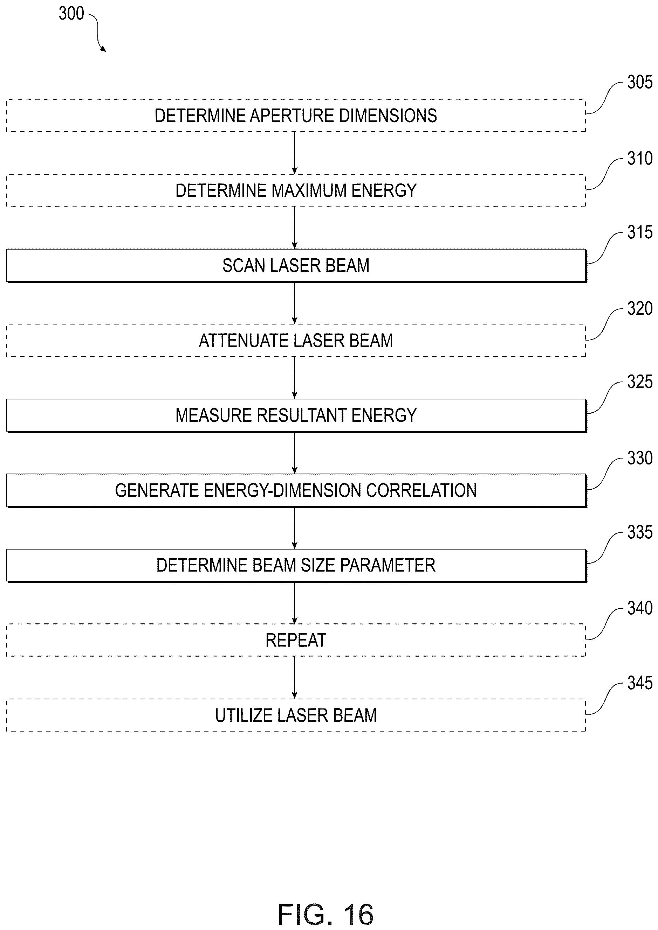

Fig. 16 is a flowchart depicting examples of methods 300 of determining a beam size parameter of a laser beam utilizing a calibration standard, according to the present disclosure. The calibration standard includes a calibration body that includes an aperture. The calibration standard defines a plurality of distinct aperture dimensions, and each distinct aperture dimension of the plurality of distinct aperture dimensions is measured along a corresponding dimension vector. Examples of the calibration standard, the calibration body, the aperture, the plurality of distinct aperture dimensions, and the corresponding dimension vector are disclosed herein with reference to calibration standard 200, calibration body 210, aperture 220, distinct aperture dimensions 222, and corresponding dimension vectors 224.

Methods 300 may include determining aperture dimensions at 305 and/or determining a maximum energy at 310. Methods 300 include scanning a laser beam at 315 and may include attenuating the laser beam at 320. Methods 300 also include measuring a resultant energy at 325, generating an energy-dimension correlation at 330, and determining the beam size parameter at 335. Methods 300 further may include repeating at 340 and/or utilizing the laser beam at 345.

Determining aperture dimensions at 305 may include determining at least a subset of the plurality of distinct aperture dimensions, or even each aperture dimension of the plurality of distinct aperture dimensions. This may be accomplished in any suitable manner. As an example, the determining at 305 may include measuring each distinct aperture dimension along the corresponding dimension vector, such as utilizing any suitable optical measurement device, electrical measurement device, and/or mechanical measurement device.

It is within the scope of the present disclosure that the plurality of distinct aperture dimensions and the corresponding dimension vectors may be predetermined, may be previously measured, and/or may be known prior to performing methods 300. In such examples, methods 300 may be performed without performing the determining at 305; however, the plurality of distinct aperture dimensions and the corresponding dimension vectors still are known and/or may be utilized to facilitate the generating at 330 and/or the determining at 335. Also in such examples, the repeating at 340 may include periodically performing the determining at 305, such as to certify that the plurality of distinct aperture dimensions has not changed and/or to quantify any changes to the plurality of distinct aperture dimensions, such as may be caused by performing methods 300.

Determining the maximum energy at 310 may include determining a maximum energy of the laser beam. When methods 300 include the determining at 310, the energy-dimension correlation further may be based, at least in part, on the maximum energy of the laser beam. The determining at 310 may be performed in any suitable manner. As an example, the determining at 310 may include directly measuring the maximum energy of the laser beam, such as via positioning the laser beam directly incident upon an optical energy detector that is utilized during the measuring at 325. This may include directly measuring the maximum energy of the laser beam absent any interaction between the laser beam and the calibration standard. In some examples, and as discussed in more detail herein, methods 300 may include attenuating the laser beam at 320. In such examples, the determining at 310 may include directly measuring an attenuated maximum energy of the laser beam by passing the laser beam through an attenuation structure to produce an attenuated laser beam and measuring the maximum energy of the attenuated laser beam.

Method 300 include performing the scanning 315 and the measuring at 320 for each distinct aperture dimension. Scanning the laser beam at 315 may include scanning the laser beam across the calibration body and along the corresponding dimension vector. This may be accomplished in any suitable manner. As an example, the scanning at 315 may include moving the calibration body relative to the laser beam. As another example, the scanning at 315 may include moving the laser beam relative to the calibration body. In some examples, the scanning at 315 may include scanning with, via, and/or utilizing a translation structure, examples of which are disclosed herein with reference to translation structure 40.

In some examples of methods 300, the corresponding dimension vector for each distinct aperture dimension may extend parallel, or at least substantially parallel, to the corresponding dimension vector for each other distinct aperture dimension of the plurality of distinct aperture dimensions. In such examples, the scanning at 315 may include scanning in (nominally) the same direction for each distinct aperture dimension.

As discussed in more detail herein, during at least a first subset of the scanning at 315, at least a first faction of the laser beam may be incident upon the calibration body. In such examples, and during a second subset of the scanning, at least a second fraction of the laser beam passes through the aperture. As also discussed in more detail herein, the corresponding dimension vector for each distinct aperture dimension may extend, or may sequentially extend, across a first region of the calibration body, across the aperture, and across a second region of the calibration body that is spaced-apart from the first region of the calibration body via the aperture. Stated differently, the scanning at 315 includes scanning the laser beam across the aperture.

In some examples, such as when the resultant energy includes resultant energy of a transmitted fraction of the laser beam that passes through the aperture, the resultant energy may define a local maximum as the function of position along the corresponding dimension vector. In some examples, such as when the resultant energy includes resultant energy of a reflected fraction of the laser beam that is reflected by the calibration body, the resultant energy may define a local minimum as the function of position along the corresponding dimension vector.

It is within the scope of the present disclosure that, during the scanning at 315, methods 300 further may include pulsing the laser. Such a configuration may decrease heating of the calibration body by the laser and/or may decrease the resultant energy, thereby decreasing a potential for damage to the calibration standard and/or for damage to an optical energy detector that is utilized to measure the resultant energy.

Attenuating the laser beam at 320 may include attenuating the laser beam to decrease an intensity of the laser beam. This may include attenuating the laser beam to decrease an intensity of the laser beam that is incident upon the optical energy detector, to decrease an intensity of the laser beam that is incident upon the calibration body, to decrease a potential for damage to the optical detector, and/or to decrease a potential for damage to the calibration body. The attenuating at 320 may be performed in any suitable manner. As an example, the attenuating at 320 may include attenuating with, via, and/or utilizing an attenuation structure, examples of which are disclosed herein with reference to attenuation structure 60.

Measuring the resultant energy at 325 may include measuring the resultant energy of the laser beam as a function of position along the corresponding dimension vector. Stated differently, the measuring at 325 may include measuring the resultant energy of the laser beam during, or concurrently with, the scanning at 315. As discussed, the measuring at 325 may include measuring the resultant energy of the reflected fraction of the laser beam and/or measuring the resultant energy of the transmitted fraction of the laser beam, examples of which are disclosed herein with reference to reflected fraction 26 and transmitted fraction 30, respectively.

In some examples, the measuring at 325 may include generating a correlation, or a correspondence, between the resultant energy of the laser beam an a position along the corresponding dimension vector for each distinct aperture dimension. Examples of the correlation include a plot, a table, and/or a functional relationship. Additional examples of the correlation are illustrated in Figs. 10, 12, and 14.

The measuring at 325 may be performed in any suitable manner. As an example, and as discussed, the measuring at 325 may include measuring the resultant energy of the laser beam with, via, and/or utilizing an optical energy detector, examples of which are disclosed herein with reference to optical energy detector 50.

It is within the scope of the present disclosure that the plurality of distinct aperture dimensions may include any suitable aperture dimensions. As an example, and as illustrated in Figs. 11A-11D, the scanning at 315 may include directing the laser beam incident upon a lane of incidence that is defined by a surface, or an upper surface, of the calibration body. Within the plane of incidence, the laser beam may define a beam diameter, or an effective beam diameter, and the plurality of distinct aperture dimensions may include at least one distinct aperture dimension that is less than the beam diameter, as illustrated in Figs. 12A-12C, and at least one distinct aperture dimension that is greater than the beam diameter, as illustrated in Fig. 11D. Such a configuration may facilitate the determining at 335, such as via permitting determination of the maximum energy of the laser beam.

It is within the scope of the present disclosure that the plurality of distinct aperture dimensions may include any suitable number of aperture dimensions. Examples of the plurality of distinct aperture dimensions include at least one, at least two, at least three, at least four, at least five, at least six, at least eight, or at least ten distinct aperture dimensions that are less than the beam diameter. Additional examples of the plurality of distinct aperture dimensions include at least one, at least two, at least three, at least four, at least five, at least six, at least eight, or at least ten distinct aperture dimensions that are greater than the beam diameter.

It is also within the scope of the present disclosure that a given distinct aperture dimension of the plurality of distinct aperture dimensions may have any suitable extent relative to the beam diameter. As examples, a ratio of the given distinct aperture dimension to the beam diameter may be at least 0.1, at least 0.2, at least 0.3, at least 0.4, at least 0.5, at least 0.6, at least 0.7, at least 0.8, at least 0.9, at least 1, at least 1.1, at least 1.2, at least 1.3, at least 1.4, at least 1.5, at least 1.6, at least 1.7, at least 1.8, at least 1.9, at least 2, at least 2.5, at least 3, at most 0.1, at most 0.2, at most 0.3, at most 0.4, at most 0.5, at most 0.6, at most 0.7, at most 0.8, at most 0.9, at most 1, at most 1.1, at most 1.2, at most 1.3, at most 1.4, at most 1.5, at most 1.6, at most 1.7, at most 1.8, at most 1.9, at most 2, at most 2.5, and/or at most 3.

Generating the energy-dimension correlation at 330 may include generating the energy-dimension correlation between a characteristic of the resultant energy for each distinct aperture dimension and the distinct aperture dimension. This may be accomplished in any suitable manner. As an example, the generating at 330 may include determining and/or tabulating the resultant energy of the laser beam for each distinct aperture dimension. As another example, the generating at 330 may include normalizing the resultant energy of the laser beam for each distinct aperture dimension by a maximum energy of the laser beam within the energy-dimension correlation and/or by the maximum energy of the laser beam as determined during the determining at 310.

The characteristic of the resultant energy of the laser beam for each distinct aperture dimension may include and/or be any suitable characteristic of the resultant energy. As an example, and such as when the resultant energy is the resultant energy of the transmitted fraction of the laser beam, the characteristic of the resultant energy may include and/or be a maximum resultant energy, as determined during the measuring at 325, for each distinct aperture dimension. As another example, and such as when the resultant energy of is the resultant energy of the reflected fraction of the laser beam, the characteristic of the resultant energy may include and/or be a minimum resultant energy, as determined during the measuring at 325, for each distinct aperture dimension.

In some examples, the generating at 330 may include generating a functional relationship between the characteristic of the resultant energy for each distinct aperture dimension and the distinct aperture dimension. This may be performed in any suitable manner, such as via curve-fitting or least-squares fitting the functional relationship to the characteristic of the resultant energy for each distinct aperture dimension as a function of the distinct aperture dimension.

Determining the beam size parameter at 335 may include determining the beam size parameter based, at least in part, on the energy-dimension correlation. This may be accomplished in any suitable manner. As an example, the determining at 335 may include correlating the beam size parameter to and/or selecting the beam size parameter as equal to a distinct aperture dimension that corresponds to a threshold resultant energy of the laser beam in the energy-dimension correlation. This is illustrated in Figs. 13 and 15, with the threshold resultant energy being indicated at 120 and the beam size parameter being indicated at 122. The threshold resultant energy of the laser beam in the energy-dimension correlation may include any suitable threshold value. In a specific example, and when the measuring at 325 includes measuring the resultant energy of the transmitted fraction of the laser beam, the threshold resultant energy of the laser beam may be 86% of a maximum energy of the laser beam in the energy-dimension correlation and/or 86% of the maximum energy of the laser beam as determined during the determining at 310. In another specific example, and when the measuring at 325 includes measuring the resultant energy of the reflected fraction of the laser beam, the threshold resultant energy of the laser beam may be 14% of the maximum energy of the laser beam in the energy-dimension correlation.

Repeating at 340 may include repeating any suitable step and/or steps of methods 300 in any suitable manner and/or for any suitable purpose. As an example, the repeating at 340 may include repeating to determine the beam size parameter in another, or in a different, direction. In a specific example, the repeating at 340 may include characterizing a beam shape of the laser beam within a transverse cross-section of the laser beam.

In such an example, the plurality of distinct aperture dimensions may be a plurality of first distinct aperture dimensions, the corresponding dimension vector may be a corresponding first dimension vector, the energy-dimension correlation may be a first energy-dimension correlation, and the beam size parameter is a first beam size parameter. The calibration standard also may define a plurality of second distinct aperture dimensions. Each second distinct aperture dimension of the plurality of distinct aperture dimensions may be measured along a corresponding second dimension vector. In such a configuration, the repeating at 340 may include repeating the scanning at 315 and the measuring at 325 for each second distinct aperture dimension, repeating the generating at 330 to generate a second energy-dimension correlation, and repeating the determining at 335 to determine a second beam size parameter that is based, at least in part, on the second energy-dimension correlation.

The corresponding second dimension vector for each second distinct aperture dimension of the plurality of second distinct aperture dimensions may extend parallel, or at least substantially parallel, to the corresponding second dimension vector for each other second distinct aperture dimension of the plurality of second distinct aperture dimensions. However, a first line that is coextensive with each corresponding first dimension vector may intersect, or be perpendicular to, a second line that is coextensive with each corresponding second dimension vector. In such a configuration, the first beam size parameter may characterize the beam size along a first direction that is parallel to the corresponding first dimension vector, while the second beam size parameter may characterize the beam size along a second direction that is parallel to the corresponding second dimension vector. Because the first direction and the second direction are not parallel to one another, the repeating at 340 may facilitate determining the beam size parameter in multiple dimensions, such as within the transverse cross-section of the laser beam.

Utilizing the laser beam at 345 may include utilizing the laser beam in any suitable manner. As an example, and as discussed in more detail herein, the laser beam may form a portion of an additive manufacturing system, examples of which are disclosed herein with reference to additive manufacturing system 10. In such examples, the utilizing at 345 may include utilizing the laser beam to melt a feedstock material as part of an additive manufacturing process that utilizes the additive manufacturing system. In such an example, the utilizing at 345 may be performed subsequent to the determining at 335 and at least one characteristic of the laser beam within the additive manufacturing process may be selected based, at least in part, on the beam size parameter. Examples of the at least one characteristic of the laser beam include an intensity of the last beam during the additive manufacturing process, a scan speed of the laser beam, a resolution of the additive manufacturing process, and/or a beam focus height of the laser beam.

Illustrative, non-exclusive examples of inventive subject matter according to the present disclosure are described as follows:
There is provided a method 300 of reproducibly determining a beam size parameter 122 of a laser beam 22 utilizing a calibration standard 200. The calibration standard 300 includes a calibration body 210 that includes an aperture 220 and defines a plurality of distinct aperture dimensions 222. Each distinct aperture dimension 222 of the plurality of distinct aperture dimensions 222 is measured along a corresponding dimension vector 224. The method 300 includes, for each distinct aperture dimension 222, scanning the laser beam 22 across the calibration body 210 and along the corresponding dimension vector 224 and, during the scanning, measuring a resultant energy of the laser beam 22 as a function of position along the corresponding dimension vector 224. The method also includes generating an energy-dimension correlation between a characteristic of the resultant energy of the laser beam 22 for each distinct aperture dimension 222 and the distinct aperture dimension 222. The method further includes determining the beam size parameter 122 based, at least in part, on the energy-dimension correlation.

In the method 300, the scanning may include moving the calibration body 210 relative to the laser beam 22.

In the method 300, the scanning may include moving the laser beam 22 relative to the calibration body 210.

In the method 300, during at least a first subset of the scanning, at least a first fraction 24 the laser beam 22 may be incident upon the calibration body 210. Further, during at least a second subset of the scanning, at least a second fraction 28 of the laser beam 22 may pass through the aperture 220.

In the method 300, the resultant energy may define a local maximum 114 in the resultant energy as the function of position along the corresponding dimension vector 224.

In the method 300, the resultant energy may define a local minimum 116 in the resultant energy as the function of position along the corresponding dimension vector 224.

During the scanning, the method 300 may further include pulsing the laser beam 22 to decrease heating of the calibration body 210 by the laser beam 22.

In the method 300, the measuring of the resultant energy of the laser beam 22 may include measuring of an energy of a reflected fraction 26 of the laser beam 22 that is reflected from the calibration body 210.

In the method 300, the measuring of the resultant energy of the laser beam 22 may include measuring of an energy of a transmitted fraction 30 of the laser beam 22 that is transmitted through the aperture 220.

The measuring of the resultant energy of the laser beam 22 may include utilizing an optical energy detector 50 to measure the resultant energy of the laser beam 22.

The optical energy detector 50 may include at least one of:
(i) a thermopile;
(ii) a charge coupled device (CCD) optical detector;
(iii) a complementary metal-oxide-semiconductor (CMOS) optical detector;
(iv) a photodiode;
(v) a calorimeter; and
(vi) an integrating sphere.

Prior to the measuring 325 of the resultant energy of the laser beam 22, the method 300 may further include attenuating 320 the laser beam 22, optionally to at least one of:
(i) decrease an intensity of the laser beam 22 that is incident upon an/the optical energy detector (50); and
(ii) decrease a potential for damage to the optical energy detector 50.

In the method 300, the generating of 330 the energy-dimension correlation may include at least one of:
(i) determining the characteristic of the resultant energy of the laser beam 22 for each distinct aperture dimension 222; and
(ii) tabulating the characteristic of the resultant energy of the laser beam 22 for each distinct aperture dimension 222.

In the method 300, the generating of the energy-dimension correlation may include normalizing the resultant energy of the laser beam 22 for each distinct aperture dimension 222 by a maximum energy of the laser beam 22 in the energy-dimension correlation.

In the method 300, the characteristic of the resultant laser beam 22 for each distinct aperture dimension 222 may be a maximum resultant energy, as determined during the measuring, for each distinct aperture dimension 222.

In the method 300, the characteristic of the resultant laser beam 22 for each distinct aperture dimension 222 may be a minimum resultant energy, as determined during the measuring, for each distinct aperture dimension 222.

In the method 300, the determining of the beam size parameter 122 may include selecting the beam size parameter 122 as equal to a distinct aperture dimension 222 that corresponds to a threshold resultant energy 120 of the laser beam 22 in the energy-dimension correlation.

The threshold resultant energy 120 of the laser beam 22 in the energy-dimension correlation may be 86% of a/the maximum energy of the laser beam 22 in the energy-dimension correlation.

The method 300 may include determining the plurality of distinct aperture dimensions 222.

The determining of the plurality of distinct aperture dimensions 222 may include measuring each distinct aperture dimension 222 of the plurality of distinct aperture dimensions 222 along the corresponding dimension vector 224.

In the method 300, the corresponding second dimension vector 224 for each second distinct aperture dimension 222 of the plurality of second distinct aperture dimensions 222 may extend parallel, or at least substantially parallel, to the corresponding second dimension vector 224 for each other second distinct aperture dimension 222 of the plurality of second distinct aperture dimensions 222.

In the method 300, a first line that is coextensive with each corresponding first dimension vector 224 may intersect a second line that is coextensive with each corresponding second dimension vector 224.

In the method 300, each corresponding first dimension vector 224 may extend perpendicular, or at least substantially perpendicular, to each corresponding second dimension vector 224.

The calibration body 210 may be a planar, or at least substantially planar, calibration body 210.

The calibration body 210 may be configured to permit repeated instances of the scanning without damage to the calibration body 210.

The calibration body 210 may be formed from a body material.

The body material may include at least one of a thermally stable body material, a body material that resists degradation by electromagnetic energy at a wavelength of the laser beam 22, a reflective body material, and a thermally conductive body material.

The body material may include at least one of a metal, a stainless steel, and copper.

In the method 300, the calibration standard 200 may be a single calibration body 210 that defines the plurality of distinct aperture dimensions 222.

The calibration standard 200 may include a plurality of calibration bodies 210, wherein each calibration body 210 of the plurality of calibration bodies 210 may include a corresponding aperture 220 and define at least one distinct aperture dimension 222 of the plurality of distinct aperture dimensions 222.

The calibration standard 200 may include a plurality of apertures 220, wherein each aperture 220 of the plurality of apertures 220 may define at least one distinct aperture dimension 222 of the plurality of distinct aperture dimensions 222.

In the method 300, the plurality of distinct aperture dimensions 222 may include:
(i) at least one, at least two, at least three, at least four, at least five, at least six, at least eight, or at least ten distinct aperture dimensions (222) that are less than the beam diameter; and
(ii) at least one, at least two, at least three, at least four, at least five, at least six, at least eight, or at least ten distinct aperture dimensions (222) that are greater than the beam diameter.

In the method 300, a ratio of a given distinct aperture dimension 222 of the plurality of distinct aperture dimensions 222 to the beam diameter is at least one of:
(i) at least 0.1, at least 0.2, at least 0.3, at least 0.4, at least 0.5, at least 0.6, at least 0.7, at least 0.8, at least 0.9, at least 1, at least 1.1, at least 1.2, at least 1.3, at least 1.4, at least 1.5, at least 1.6, at least 1.7, at least 1.8, at least 1.9, at least 2, at least 2.5, or at least 3; and
(ii) at most 0.1, at most 0.2, at most 0.3, at most 0.4, at most 0.5, at most 0.6, at most 0.7, at most 0.8, at most 0.9, at most 1, at most 1.1, at most 1.2, at most 1.3, at most 1.4, at most 1.5, at most 1.6, at most 1.7, at most 1.8, at most 1.9, at most 2, at most 2.5, or at most 3.

The method 300 may also include determining a maximum energy of the laser beam 22, wherein the energy-dimension correlation is based, at least in part, on the maximum energy of the laser beam 22.

The determining of the maximum energy of the laser beam 22 may include directly measuring the maximum energy of the laser beam 22.

The determining of the maximum energy of the laser beam may be via positioning the laser beam 22 directly incident upon an/the optical energy detector 50.

In the method 300, at least one of the following aspects may be fulfilled:
(i) The directly measuring the maximum energy of the laser beam 22 includes directly measuring the maximum energy of the laser beam (22) absent any interaction between the laser beam (22) and the calibration standard (200); and
(ii) Directly measuring an attenuated maximum energy of the laser beam 22 by passing the laser beam 22 through an attenuation structure 60 to produce an attenuated laser beam 22 and measuring the maximum energy of the attenuated laser beam 22.

There may be provide an additive manufacturing system 10 configured to form an additively manufactured component, the additive manufacturing system 10 comprising:
a calibration standard 200, wherein the calibration standard 200 includes a calibration body 210 that includes an aperture 220, wherein the calibration standard 200 defines a plurality of distinct aperture dimensions 222, and further wherein each distinct aperture dimension 222 of the plurality of distinct aperture dimensions 222 is measured along a corresponding dimension vector 224; a laser light source 20 configured to direct a laser beam 22 incident upon the calibration standard 200; a translation structure 40 configured scan the laser beam 22 across the calibration body 210 of the calibration standard 200; and a controller (100) programmed to control operation of the additive manufacturing system 10 according to the method 300.

The additive manufacturing system 10 may be configured to utilize the translation structure 40 to perform the scanning the laser beam 22.

The translation structure 40 may be configured to move the calibration body 210 relative to the laser light source 20.

The translation structure 40 may be configured to move the laser beam 22 relative to the calibration body 210.

The translation structure may 40 includes, or may be, a beam scanner 42.

The additive manufacturing system 10 may includes an/the optical energy detector 50. The additive manufacturing system 10 may be configured to utilize the optical energy detector 50 to perform the measuring the resultant energy.

The calibration standard 200 may be positioned between the laser light source 20 and the optical energy detector 50 such that the measuring the resultant energy includes measuring an energy of a/the transmitted fraction 30 of the laser beam 22 that is transmitted through the aperture 220.

The optical energy detector 50 may be positioned to detect a/the reflected fraction 26 of the laser beam 22 that is reflected from the calibration body 210.

The additive manufacturing system 10 may further include an/the attenuation structure 60 configured to attenuate the laser beam 22, optionally to at least one of:
(i) decrease an/the intensity of the laser beam 22 that is incident upon an/the optical energy detector 50; and
(ii) decrease a/the potential for damage to the optical energy detector 50.

The additive manufacturing system 10 may further include a support platform 70 configured to support the additively manufactured component, optionally wherein the calibration standard 200 is supported by the support platform 70.

The additive manufacturing system 10 may further include a volume of a/the feedstock material 82, wherein the additive manufacturing system 10 is configured to utilize the laser beam 22 to form a/the melt pool of the feedstock material 82 to form the additively manufactured component.

The additive manufacturing system 10 may further include a feedstock supply system (80) configured to supply the feedstock material 82.

The additive manufacturing system 10 may further include a build chamber 90 that at least partially defines a chamber volume 92 that contains at least the calibration standard 200.

The additive manufacturing system 10 may further include a/the beam scanner 42 configured to move the laser beam 22 relative to a/the support platform 70, wherein the beam scanner 42 is distinct from the translation structure 40.

As used herein, the terms "selective" and "selectively," when modifying an action, movement, configuration, or other activity of one or more components or characteristics of an apparatus, mean that the specific action, movement, configuration, or other activity is a direct or indirect result of user manipulation of an aspect of, or one or more components of, the apparatus.

As used herein, the terms "adapted" and "configured" mean that the element, component, or other subject matter is designed and/or intended to perform a given function. Thus, the use of the terms "adapted" and "configured" should not be construed to mean that a given element, component, or other subject matter is simply "capable of" performing a given function but that the element, component, and/or other subject matter is specifically selected, created, implemented, utilized, programmed, and/or designed for the purpose of performing the function. It is also within the scope of the present disclosure that elements, components, and/or other recited subject matter that is recited as being adapted to perform a particular function may additionally or alternatively be described as being configured to perform that function, and vice versa. Similarly, subject matter that is recited as being configured to perform a particular function may additionally or alternatively be described as being operative to perform that function.

As used herein, the phrase "at least one," in reference to a list of one or more entities should be understood to mean at least one entity selected from any one or more of the entity in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a non-limiting example, "at least one of A and B" (or, equivalently, "at least one of A or B," or, equivalently "at least one of A and/or B") may refer, in one embodiment, to at least one, optionally including more than one, A, with no B present (and optionally including entities other than B); in another embodiment, to at least one, optionally including more than one, B, with no A present (and optionally including entities other than A); in yet another embodiment, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C" and "A, B, and/or C" may mean A alone, B alone, C alone, A and B together, A and C together, B and C together, A, B, and C together, and optionally any of the above in combination with at least one other entity.

The various disclosed elements of apparatuses and steps of methods disclosed herein are not required to all apparatuses and methods according to the present disclosure, and the present disclosure includes all novel and non-obvious combinations and subcombinations of the various elements and steps disclosed herein. Moreover, one or more of the various elements and steps disclosed herein may define independent inventive subject matter that is separate and apart from the whole of a disclosed apparatus or method. Accordingly, such inventive subject matter is not required to be associated with the specific apparatuses and methods that are expressly disclosed herein, and such inventive subject matter may find utility in apparatuses and/or methods that are not expressly disclosed herein.

As used herein, the phrase, "for example," the phrase, "as an example," and/or simply the term "example," when used with reference to one or more components, features, details, structures, embodiments, and/or methods according to the present disclosure, are intended to convey that the described component, feature, detail, structure, embodiment, and/or method is an illustrative, non-exclusive example of components, features, details, structures, embodiments, and/or methods according to the present disclosure. Thus, the described component, feature, detail, structure, embodiment, and/or method is not intended to be limiting, required, or exclusive/exhaustive; and other components, features, details, structures, embodiments, and/or methods, including structurally and/or functionally similar and/or equivalent components, features, details, structures, embodiments, and/or methods, are also within the scope of the present disclosure.

As used herein, "at least substantially," when modifying a degree or relationship, may include not only the recited "substantial" degree or relationship, but also the full extent of the recited degree or relationship. A substantial amount of a recited degree or relationship may include at least 75% of the recited degree or relationship. For example, an object that is at least substantially formed from a material includes objects for which at least 75% of the objects are formed from the material and also includes objects that are completely formed from the material. As another example, a first length that is at least substantially as long as a second length includes first lengths that are within 75% of the second length and also includes first lengths that are as long as the second length.

## Claims

1. A method (300) of reproducibly determining a beam size parameter (122) of a laser beam (22) utilizing a calibration standard (200), wherein the calibration standard (200) includes a calibration body (210) that includes an aperture (220), wherein the calibration standard (200) defines a plurality of distinct aperture dimensions (222), and further wherein each distinct aperture dimension (222) of the plurality of distinct aperture dimensions (222) is measured along a corresponding dimension vector (224), the method (300) comprising:
for each distinct aperture dimension (222):
(i) scanning (315) the laser beam (22) across the calibration body (210) and along the corresponding dimension vector (224); and
(ii) during the scanning (315), measuring (325) a resultant energy of the laser beam (22) as a function of position along the corresponding dimension vector (224);
generating (330) an energy-dimension correlation between a characteristic of the resultant energy of the laser beam (22) for each distinct aperture dimension (222) and the distinct aperture dimension (222); and
determining (335) the beam size parameter (122) based, at least in part, on the energy-dimension correlation.

2. The method (300) of claim 1, wherein the corresponding dimension vector (224) for each distinct aperture dimension (222) of the plurality of distinct aperture dimensions (222) extends at least substantially parallel to the corresponding dimension vector (224) for each other distinct aperture dimension (222) of the plurality of distinct aperture dimensions (222).

3. The method (300) of any one of claims 1 or 2, wherein the corresponding dimension vector (224) extends across a first region (226) of the calibration body (210), across the aperture (220), and across a second region (228) of the calibration body (210) that is spaced-apart from the first region (226) of the calibration body (210) via the aperture (220).

4. The method (300) of any one of claims 1-3, wherein the measuring (325) the resultant energy includes generating a correlation between the resultant energy of the laser beam (22) and a position along the corresponding dimension vector (224) for each distinct aperture dimension (222).

5. The method (300) of any one of claims 1-4, wherein the characteristic of the resultant energy of the laser beam (22) for each distinct aperture dimension (222) includes a maximum resultant energy or a minimum resultant energy, as determined during the measuring (325), for each distinct aperture dimension (222).

6. The method (300) of any one of claims 1-5, wherein the determining (335) the beam size parameter (122) includes correlating the beam size parameter (122) to a distinct aperture dimension (222) that corresponds to a threshold resultant energy (120) of the laser beam (22) in the energy-dimension correlation.

7. The method (300) of any one of claims 1-6, wherein the plurality of distinct aperture dimensions (222) is a plurality of first distinct aperture dimensions (222), wherein the corresponding dimension vector (224) is a corresponding first dimension vector (224), wherein the calibration standard (200) also defines a plurality of second distinct aperture dimensions (222), wherein each second distinct aperture dimension (222) of the plurality of distinct aperture dimensions (222) is measured along a corresponding second dimension vector (224), wherein the energy-dimension correlation is a first energy-dimension correlation, wherein the beam size parameter is a first beam size parameter (122), and further wherein the method (300) includes:
(i) repeating (340) the scanning (315) the laser beam (22) and the measuring (325) the resultant energy for each second distinct aperture dimension (222);
(ii) repeating (340) the generating (330) to generate a second energy-dimension correlation; and
(iii) repeating (340) the determining (335) to determine a second beam size parameter (122) that is based, at least in part, on the second energy-dimension correlation.

8. The method (300) of claim 7, wherein the repeating (340) includes characterizing a beam shape of the laser beam (22) within a transverse cross-section of the laser beam (22).

9. The method (300) of any one of claims 7 or 8, wherein the corresponding second dimension vector (224) for each second distinct aperture dimension (222) of the plurality of second distinct aperture dimensions (222) extends at least substantially parallel to the corresponding second dimension vector (224) for each other second distinct aperture dimension (222) of the plurality of second distinct aperture dimensions (222), and further wherein each corresponding first dimension vector (224) extends at least substantially perpendicular to each corresponding second dimension vector (224).

10. The method (300) of any one of claims 1-9, wherein the calibration standard (200) includes a single calibration body (210) that defines the plurality of distinct aperture dimensions (222).

11. The method (300) of any one of claims 1-10, wherein the calibration standard (200) includes a single aperture (220) that defines the plurality of distinct aperture dimensions (222).

12. The method (300) of any one of claims 1-11, wherein the aperture (220) is a size-adjustable aperture (220) configured to be selectively adjusted to define the plurality of distinct aperture dimensions (222).

13. The method (300) of any one of claims 1-12, wherein the scanning includes directing the laser beam (22) incident upon a plane of incidence that is defined by a surface of the calibration body (210), wherein, within the plane of incidence, the laser beam (22) defines a beam diameter and further wherein the plurality of distinct aperture dimensions (222) includes at least one distinct aperture dimension (222) that is less than the beam diameter and at least one distinct aperture dimension (222) that is greater than the beam diameter.

14. The method (300) of any one of claims 1-13, wherein, subsequent to determining the beam size parameter (122), the method (300) further includes utilizing (345) the laser beam (22) to melt a feedstock material (82) as part of an additive manufacturing process, and further wherein the utilizing (345) includes at least one of:
(i) selecting an intensity of the laser beam (22) during the additive manufacturing process based, at least in part, on the beam size parameter (122);
(ii) selecting as scan speed of the laser beam (22) during the additive manufacturing process based, at least in part, on the beam size parameter (122);
(iii) selecting a resolution of the additive manufacturing process based, at least in part, on the beam size parameter (122); and
(iv) selecting a beam focus height of the laser beam (22) during the additive manufacturing process based, at least in part, on the beam size parameter (122).

15. An additive manufacturing system (10) configured to form an additively manufactured component, the additive manufacturing system (10) comprising:
a calibration standard (200), wherein the calibration standard (200) includes a calibration body (210) that includes an aperture (220), wherein the calibration standard (200) defines a plurality of distinct aperture dimensions (222), and further wherein each distinct aperture dimension (222) of the plurality of distinct aperture dimensions (222) is measured along a corresponding dimension vector (224);
a laser light source (20) configured to direct a laser beam (22) incident upon the calibration standard (200);
a translation structure (40) configured scan the laser beam (22) across the calibration body (210) of the calibration standard (200); and
a controller (100) programmed to control operation of the additive manufacturing system (10) according to the method (300) of claim 1.
